# EUROPÄISCHE PATENTANMELDUNG

(11) **EP 1 328 140 A2**
(43) Veröffentlichungstag der Anmeldung: **16.07.2003**
(21) Anmeldenummer: 03000372.7
(22) Anmeldetag: 10.01.2003
(51) Int. Cl.: H05K 1/18, B60Q 1/00, F21S 8/10

(54) **Leiterbahn aus flexiblem Material, Baueinheit mit einer solchen flexiblen Leiterbahn und Verfahren zur Herstellung einer solchen Leiterbahn**

(30) Priorität: 12.01.2002 DE 10200961; 20.12.2002 DE 10261772
(71) Anmelder: Schefenacker Vision Systems Germany GmbH & Co. KG, 73730 Esslingen (DE)
(72) Erfinder: Schreck, Wolfgang, 73730 Esslingen (DE); Scholz, Jochen, 73547 Lorch (DE); Romberg, Andreas, Dr., 71522 Backnang (DE)
(74) Vertreter: Jackisch-Kohl, Anna-Katharina

(57) **Zusammenfassung**

Um bei Leuchteneinheiten für Kraftfahrzeuge die flexible Leiterbahn (9) in einfacher Weise in einer gewünschten Einbaulage montieren zu können, ist sie wenigstens teilweise in ein formbeständiges Bauteil (2) eingebettet. Durch dieses Bauteil (2) erhält die Leiterbahn (9) eine Formstabilität, so daß sie problemlos montiert werden kann. Sie wird zunächst mit den elektronischen und/oder elektrischen Bauteilen (4) bestückt, anschließend in eine Spritzgußform eingesetzt und wenigstens teilweise mit Kunststoff umspritzt. Die Leiterbahn (9) wird insbesondere bei Leuchteinheiten von Kraftfahrzeugen eingesetzt.

## Beschreibung

Die Erfindung betrifft eine Leiterbahn aus flexiblem Material nach dem Oberbegriff des Anspruches 1, eine Baueinheit nach dem Oberbegriff des Anspruches 7 sowie ein Verfahren zur Herstellung einer solchen Leiterbahn nach dem Oberbegriff des Anspruches 18.

Es ist beispielsweise bei Leuchteneinheiten für Kraftfahrzeuge bekannt, im Leuchtengehäuse einen Reflektor anzuordnen, der von LEDs ausgesandtes Licht nach außen reflektiert. Die LEDs sitzen auf einer flexiblen Leiterfolie. Die Montage der flexiblen Leiterbahn mit den LEDs ist aufwendig, da die LEDs innerhalb der Leuchteneinheit in eine genaue Einbauposition gebracht werden müssen. Dies ist infolge der Flexibilität der Leiterbahn schwierig.

Der Erfindung liegt die Aufgabe zugrunde, die gattungsgemäße Leiterbahn, die gattungsgemäße Baueinheit und das gattungsgemäße Verfahren so auszubilden, daß die flexible Leiterbahn in einfacher Weise in einer gewünschten Einbaulage montiert werden kann.

Diese Aufgabe wird bei der gattungsgemäßen Leiterbahn erfindungsgemäß mit den kennzeichnenden Merkmalen des Anspruches 1, bei der gattungsgemäßen Baueinheit erfindungsgemäß mit den kennzeichnenden Merkmalen des Anspruches 7 und beim gattungsgemäßen Verfahren erfindungsgemäß mit den kennzeichnenden Merkmalen des Anspruches 18 gelöst.

Die erfindungsgemäße flexible Leiterbahn ist wenigstens teilweise in das formbeständige Bauteil eingebettet. Über dieses formbeständige Bauteil erhält die Leiterbahn ihre Formstabilität, so daß sie problemlos in einer genauen Einbaulage montiert werden kann. Zudem ist die Leiterbahn im formbeständigen Bauteil vor Beschädigung geschützt.

Bei der erfindungsgemäßen Baueinheit ist die flexible Leiterbahn wenigstens teilweise in die Kunststoffschicht eingebettet. Darum muß die Leiterbahn bei der Montage der Baueinheit nicht gesondert montiert werden, sondern bildet zusammen mit der formstabilen Kunststoffschicht eine Baueinheit, die einfach montiert werden kann.

Die Leiterbahn wird beim erfindungsgemäßen Verfahren zunächst mit dem elektronischen und/oder elektrischen Bauteil bestückt und anschließend in die Spritzgußform eingesetzt und dort lagegesichert. Dann wird die Leiterbahn wenigstens teilweise mit Kunststoff umspritzt. Nach dem Aushärten dieses Kunststoffes kann die teilweise eingebettete Leiterbahn der Spritzgußform entnommen werden.

Weitere Merkmale der Erfindung ergeben sich aus den weiteren Ansprüchen, der Beschreibung und den Zeichnungen.

Die Erfindung wird anhand eines in den Zeichnungen dargestellten Ausführungsbeispiels näher erläutert. Es zeigen
- Fig. 1: im Schnitt ein Teil einer Leuchteneinheit mit einer erfindungsgemäßen Leiterbahn,
- Fig. 2: in perspektivischer Darstellung einen Reflektor der Leuchteneinheit gemäß Fig. 1, an dem die erfindungsgemäße Leiterbahn vorgesehen ist,
- Fig. 3: in vergrößerter Darstellung und im Schnitt einen Teil der erfindungsgemäßen Leiterbahn,
- Fig. 4: im Schnitt und in vereinfachter Darstellung eine Spritzgußform zur Herstellung der erfindungsgemäßen Leiterbahn,
- Fig. 5 und 6: jeweils eine weitere Ausführungsform einer erfindungsgemäßen Baueinheit in einer Darstellung entsprechend Fig. 3.

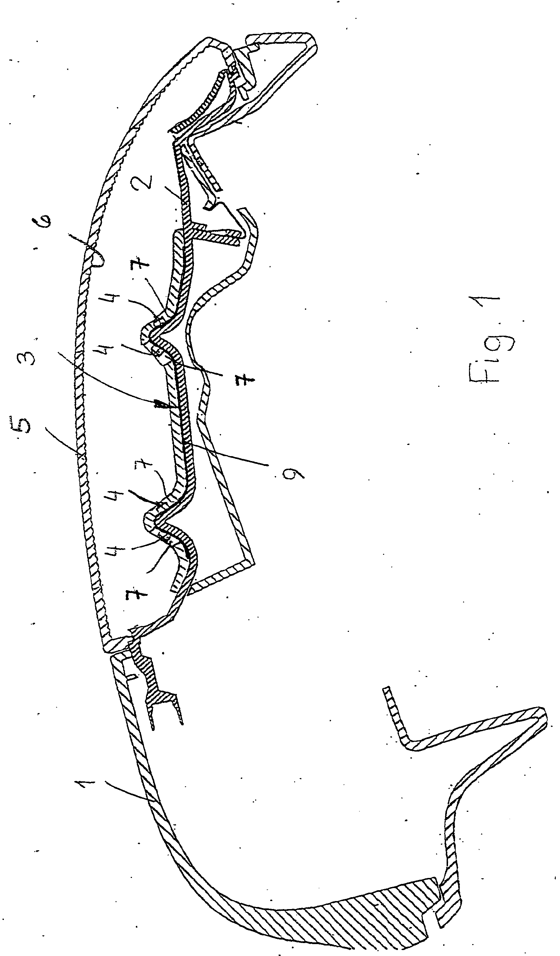

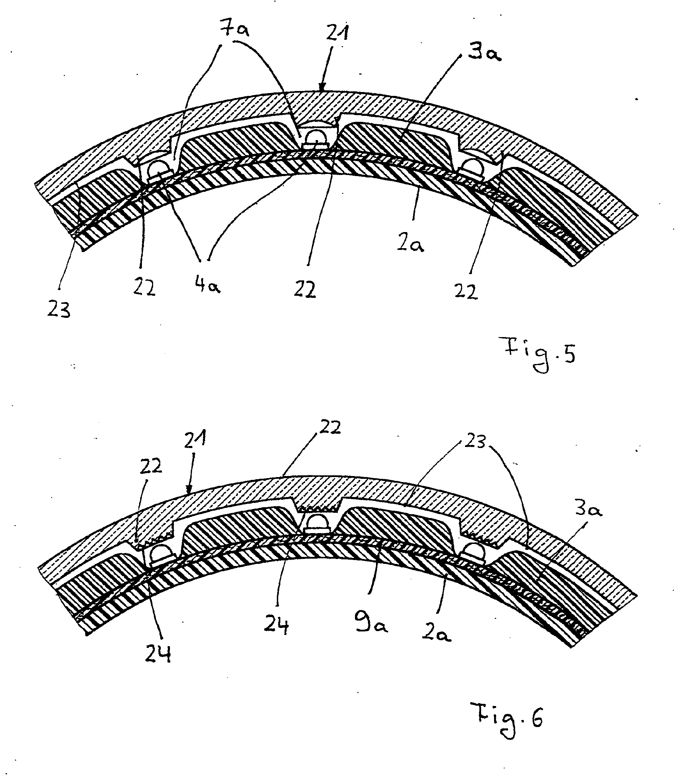

Fig. 1 zeigt eine Leuchteinheit, die im Ausführungsbeispiel eine Rückleuchte eines Kraftfahrzeuges ist. Die Leuchteneinheit hat ein Gehäuse 1, in dem ein Träger 2 untergebracht ist. Er besteht vorzugsweise aus Kunststoff, kann aber aus jedem anderen geeigneten Material bestehen. Der Träger 2 ist mit einem Reflektor 3 einstückig ausgebildet, mit dem von Leuchtmitteln 4 ausgesandte Strahlen zu einer Lichtscheibe 5 reflektiert werden, durch die das Licht nach außen gelangt. Die Ausbildung einer solchen Rückleuchte von Kraftfahrzeugen ist bekannt und wird darum auch nicht näher beschrieben. Die Lichtscheibe 5 kann an ihrer Innenseite mit Leuchtoptiken 6 versehen sein, wie noch anhand der Ausführungsbeispiele gemäß den Figuren 5 und 6 erläutert wird.

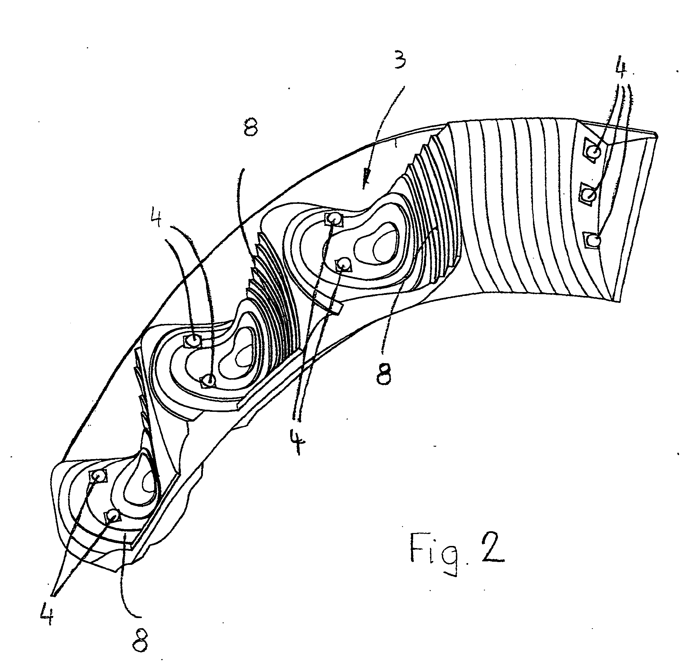

Der Reflektor 3 hat Öffnungen 7, in denen die Leuchtmittel 4 liegen. Der Reflektor 3 hat, wie Fig. 2 zeigt, für jedes Leuchtmittel 4 entsprechende Reflektorflächen 8. Die Leuchtmittel 4 sind vorteilhaft LEDs, die auf einer Leiterbahn 9 sitzen. Als Leuchtmittel 4 können auch SMDs verwendet werden. Wie Fig. 2 zeigt, sind die Leuchtmittel 4 im Ausführungsbeispiel im Bereich der Reflektorflächen jeweils paarweise vorgesehen. Je nach Ausbildung des Reflektors 3 können auch mehrere solcher Leuchtmittel 4 der entsprechenden Reflektorfläche 8 zugeordnet sein. Ebenso ist es selbstverständlich möglich, für jede Reflektorfläche 8 nur ein einziges Leuchtmittel 4 vorzusehen. Im Ausführungsbeispiel sind seitlich drei weitere, mit Abstand nebeneinander liegende Leuchtmittel 4 vorgesehen, die ebenfalls vorteilhaft LEDs sind und die nicht durch die Lichtscheibe 4 abstrahlen, sondern quer hierzu.

Die Leiterbahn 9 ist eine flexible Leiterfolie, über die die Stromzuführung zu den Leuchtmitteln 4 in bekannter Weise erfolgt. Da die Leiterfolie 9 flexibel ist, kann sie an jede Form des Trägers 2 und/oder des Reflektors 3 angepaßt werden.

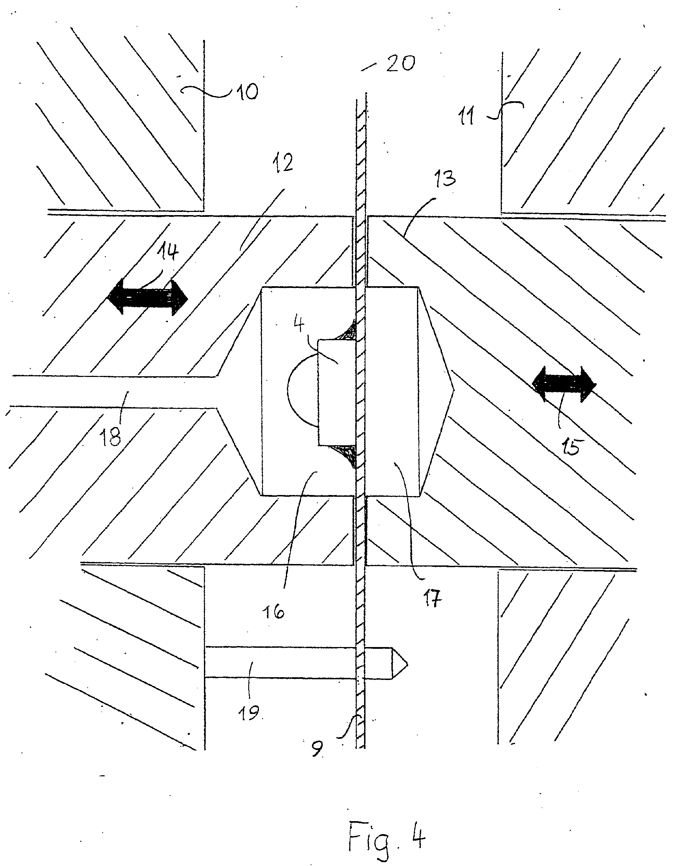

Der Träger 2 und der Reflektor 3 umschließen die Leiterbahn 9. Bei der Herstellung des Trägers 2 und des Reflektors 3 wird die Leiterbahn 9 vom Material dieser beiden Teile 2, 3 umspritzt. Dadurch ist die Leiterbahn 9 einwandfrei gesichert und geschützt. Fig. 4 zeigt schematisch einen Teil einer Spritzgußform. Sie hat zwei Formteile 10, 11, von denen das Formteil 10 fest und das Formteil 11 beweglich ist. Beide Formteile 10, 11 weisen jeweils wenigstens einen Haltestempel 12, 13 auf, die gegeneinander beweglich in den Formteilen 10, 11 angeordnet sind und zwischen denen die flexible Leiterbahn 9 während des Spritzgußvorganges eingeklemmt wird. Die beiden Haltestempel 12, 13 sind in Richtung der in Fig. 4 eingezeichneten Doppelpfeile 14, 15 verstellbar. Beide Haltestempel 12, 13 sind so ausgebildet, daß sie wenigstens einen Hohlraum 16, 17 aufweisen. Die beiden Hohlräume 16, 17 liegen einander gegenüber und bilden einen gemeinsamen, von der Leiterbahn 9 unterteilten Hohlraum. Er ist so ausgebildet, daß das auf der Leiterbahn 9 befestigte Leuchtmittel 4 während des Spritzgußvorganges aufgenommen werden kann. Die beiden Haltestempel 12, 13 klemmen die Leiterbahn 9 im Bereich neben dem Leuchtmittel 4 so, daß der in die Spritzgußform eingebrachte Kunststoff nicht in den Hohlraum 16, 17 eindringen kann.

Entsprechend der Zahl der Leuchtmittel 4, die auf der Leiterbahn 9 sitzen, sind Haltestempel mit entsprechenden Hohlräumen in der Spritzgußform vorgesehen.

In den Hohlraum 16 des einen Haltestempels 12 kann ein Vakuumkanal 18 münden, über den der Hohlraum während des Spritzgußvorganges unter Vakuum gesetzt werden kann.

Die Spritzgußform kann zusätzlich mit wenigstens einem Bestükkungsstempel 19 versehen sein.

In die Spritzgußform wird in bekannter Weise der für den Träger 2 und den Reflektor 3 vorgesehene Kunststoff eingespritzt. Die zwischen den Haltestempeln 12, 13 im Hohlraum 20 eingespannte Leiterbahn 9 wird mit diesem Kunststoff umspritzt. Die auf der Leiterbahn 9 befindlichen Leuchtmittel 4 sind während dieses Spritzgußvorganges im Hohlraum 16, 17 der Haltestempel 12, 13 geschützt. Die Haltestempel 12, 13 sind so ausgebildet, daß sie die Leiterbahn 9 nur im unmittelbaren Bereich der Leuchtmittel 4 festklemmen, so daß im übrigen Bereich die Leiterbahn 9 vom Kunststoff für den Träger 2 und den Reflektor 3 umhüllt werden kann. Infolge der Einspannung der Leiterbahn 9 durch die Haltestempel 12, 13 ist sichergestellt, daß die Leuchtmittel 4 ihre exakte Einbaulage am Träger 2 sowie am Reflektor 3 einnehmen. Die flexible, folienartige Leiterbahn 9 selbst muß keine genaue Einbaulage haben, da sie vom Kunststoff des Trägers 2 und des Reflektors 3 umspritzt und damit lagegesichert wird. Nach dem Spritzvorgang wird die Spritzgußform geöffnet, so daß die aus dem Träger 2, dem Reflektor 3 und der eingebetteten Leiterbahn 9 bestehende Einheit herausgenommen und in das Gehäuse 1 eingebaut werden kann. Dadurch gestaltet sich die Herstellung und die Montage der Leuchteneinheit einfach und kostengünstig.

Die Leuchteneinheit kann beispielsweise eine Blinkerleuchte, eine Heckleuchte, eine Scheinwerferleuchte oder allgemein eine Signalleuchte eines Kraftfahrzeuges sein. Die eingebettete Leiterbahn kann aber auch für die Innenraum- und/oder Instrumentenbeleuchtung bei Kraftfahrzeugen eingesetzt werden, beispielsweise als Armaturenleuchte, Cockpitleuchte, Türgriffbeleuchtung und dergleichen.

Auf der in den Kunststoff eingebetteten Leiterbahn 9 können außer Leuchtmitteln beispielsweise auch Sensoren oder andere elektronische und/oder elektrische Bauteile befestigt sein. Die eingebettete Leiterbahn 9 kann außer bei Kraftfahrzeugen beispielsweise auch bei Kameras, akustischen Signalgebern und dergleichen eingesetzt werden.

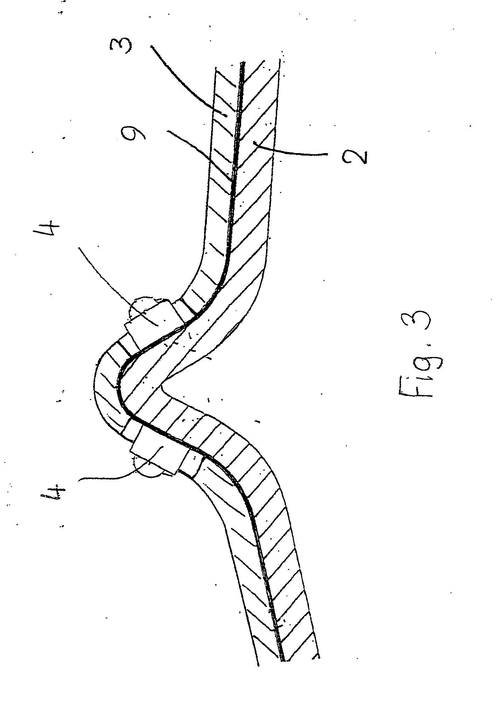

Fig. 5 zeigt eine Leuchteneinheit, bei der die Leiterbahn 9a entsprechend wie bei der zuvor beschriebenen Ausführungsform zwischen einem Träger 2a und einem Reflektor 3a angeordnet ist. Die Leiterbahn 9a trägt ebenfalls LEDs 4a, die in Öffnungen 7a des Reflektors 3a liegen. Diese Leuchteneinheit unterscheidet sich von der gemäß Fig. 1 bis 4 nur dadurch, daß anstelle der Lichtscheibe 5 ein Lichtleiter 21 vorgesehen ist, der in bekannter Weise aus lichtleitendem Kunststoff hergestellt wird. Der Lichtleiter 21 weist Optiken 22 auf, die durch angeformte kegelstumpfförmige Vorsprünge auf der Innenseite 23 des Lichtleiters 21 gebildet sind. Jeder LED 4a ist jeweils eine Optik 22 zugeordnet. Durch diese in den Lichtleiter 21 integrierten Optiken 22 kann die herkömmliche Lichtscheibe 5 entfallen. Leuchten mit einer solchen Ausbildung bauen extrem flach und benötigen daher nur einen geringen Einbauraum am Fahrzeug. Vorteilhaft kann dadurch ein geschlossenes Blech am Fahrzeug verwendet werden. Außerdem besteht diese Leuchteneinheit aus nur wenigen Einzelteilen, so daß sie kostengünstig hergestellt und montiert werden kann. Ferner können auch bedampfte Teile entfallen. Schließlich sind auch keine Filter im Lichtfenster erforderlich, um einen gewünschten Farbton zu erzeugen, da der Lichtleiter 21 in verschiedenen Farben eingesetzt werden kann. Bei dieser Ausführungsform ist es ferner möglich, anstelle des Reflektors 3a nur eine Kunststoffschicht vorzusehen, die lediglich an ihrer dem Lichtleiter 21 zugewandten Seite mit einer (nicht dargestellten) Elektrolumineszenz-Folie oder einem Reflektorband versehen ist. Vorzugsweise wird die Folie bzw. das Band in die Außenseite der Kunststoffschicht 2a eingelegt.

Wie Fig. 6 zeigt, können die Optiken 22 an ihrer den LEDs 4a zugewandten Stirnfläche 24 auch profiliert ausgebildet sein und dadurch als Reflektor dienen.

Da die Leiterbahnen 9, 9a von Kunststoff ummantelt sind, ergibt sich eine optimale Wärmeverteilung und Wärmeableitung. Zusätzliche Maßnahmen zur Wärmeverteilung bzw. Wärmeableitung sind darum nicht erforderlich.

Als Kunststoff für den Träger 2 bzw. 2a und/oder den Reflektor 3 kommen Thermoplaste, wie Polycarbonat, Acrylnitril-Butadien-Styrol-Copo-lymere (ABS), Polybutylenterephtalat (PBT), Polyamid und dergleichen in Betracht. Thermoplaste haben einen verhältnismäßig niedrigen Schmelzpunkt, so daß beim Spritzgießen des Trägers 2, 2a und des Reflektors 3, 3a keine Gefahr für die auf der Leiterbahn 9, 9a befindlichen elektrischen und/oder elektronischen Bauteile 4, 4a besteht.

Dem Kunststoff können zur besseren Wärmeableitung Zusatzstoffe beigemischt werden, wie Mineralstoffe, Glas, Mehl, Fasern, Keramiken und dergleichen. Diese Zusatzstoffe können bis zu etwa 60 Gew.-% betragen.

## Patentansprüche

1. Leiterbahn aus flexiblem Material, auf dem sich elektronische und/oder elektrische Bauteile befinden,
**dadurch gekennzeichnet, daß** die Leiterbahn (9, 9a) wenigstens teilweise in ein formbeständiges Bauteil (2, 2a, 3, 3a) eingebettet ist.

2. Leiterbahn nach Anspruch 1,
**dadurch gekennzeichnet, daß** das formbeständige Bauteil (2, 2a, 3, 3a) aus Kunststoff besteht.

3. Leiterbahn nach Anspruch 2,
**dadurch gekennzeichnet, daß** der Kunststoff wenigstens ein Thermoplast ist.

4. Leiterbahn nach Anspruch 2 oder 3,
**dadurch gekennzeichnet, daß** der Kunststoff vorteilhaft bis zu etwa 60 Gew.-% Zusatzstoffe enthält, die vorzugsweise aus wärmeableitendem Material, wie Mineralstoffe, Fasern, Keramiken und dergleichen, bestehen.

5. Leiterbahn nach einem der Ansprüche 1 bis 4,
**dadurch gekennzeichnet, daß** das formbeständige Bauteil (2, 2a; 3, 3a) aus zwei Funktionsträgern besteht.

6. Leiterbahn nach einem der Ansprüche 1 bis 5,
**dadurch gekennzeichnet, daß** das formbeständige Bauteil (2, 2a, 3, 3a) im Bereich des elektronischen und/oder elektrischen Bauteiles (4, 4a) freigespart ist.

7. Baueinheit, insbesondere für Kraftfahrzeuge, mit wenigstens einer flexiblen Leiterbahn, auf der sich wenigstens ein elektrisches und/oder elektronisches Bauteil befindet, insbesondere nach einem der Ansprüche 1 bis 6,
**dadurch gekennzeichnet, daß** die flexible Leiterbahn (9, 9a) in eine Kunststoffschicht (3, 3a) zumindest teilweise eingebettet ist.

8. Baueinheit nach Anspruch 7,
**dadurch gekennzeichnet, daß** die Kunststoffschicht (3, 3a) auf einem Träger (2, 2a) angeordnet ist.

9. Baueinheit nach Anspruch 7 oder 8,
**dadurch gekennzeichnet, daß** der Träger (2, 2a) und die Kunststoffschicht (3, 3a) einstückig miteinander ausgebildet sind.

10. Baueinheit nach einem der Ansprüche 7 bis 9,
**dadurch gekennzeichnet, daß** das Leuchtmittel (4, 4a) durch eine Öffnung (7, 7a) der Kunststoffschicht (3, 3a) ragt, die vorteilhaft einen Reflektor bildet.

11. Baueinheit nach einem der Ansprüche 7 bis 10,
**dadurch gekennzeichnet, daß** das Leuchtmittel (4, 4a) eine LED oder eine SMD ist.

12. Baueinheit nach einem der Ansprüche 7 bis 11,
**dadurch gekennzeichnet, daß** vor der Kunststoffschicht (3a) und/oder vor dem Leuchtmittel (4a) ein Lichtleiter (21) angeordnet ist.

13. Baueinheit nach Anspruch 12,
**dadurch gekennzeichnet, daß** der vorteilhaft mehrfarbig ausgebildete Lichtleiter (21) mindestens eine dem Leuchtmittel (4a) zugeordnete, vorzugsweise am Lichtleiter (21) angeformte Leuchtenoptik (22) aufweist.

14. Baueinheit nach Anspruche 13,
**dadurch gekennzeichnet, daß** die Leuchtenoptik (22) durch einen über die Innenseite (23) des Lichtleiters (21) vorstehenden Ansatz gebildet ist.

15. Baueinheit nach Anspruch 13 oder 14,
**dadurch gekennzeichnet, daß** jedem Leuchtmittel (4a) jeweils eine Leuchtenoptik (22) zugeordnet ist, die vorteilhaft mindestens eine vorzugsweise durch eine zahnartige Profilierung der Stirnflächen der Optik (22) gebildete Reflektorfläche (24) aufweist.

16. Baueinheit nach einem der Ansprüche 7 bis 15,
**dadurch gekennzeichnet, daß** die Kunststoffschicht (3a) in ihrer dem Lichtleiter (21) zugewandten Seite mindestens ein Reflektorteil aufweist.

17. Baueinheit nach einem der Ansprüche 9 bis 23,
**dadurch gekennzeichnet, daß** die Baueinheit für eine Leuchteneinheit eines Kraftfahrzeuges verwendet wird.

18. Verfahren zur Herstellung der Leiterbahn nach einem der Ansprüche 1 bis 6,
**dadurch gekennzeichnet, daß** auf die flexible Leiterbahn (9, 9a) das elektronische und/oder elektrische Bauteil (4, 4a) aufgebracht wird, daß die mit dem Bauteil (4, 4a) bestückte Leiterbahn (9, 9a) in eine Spritzgußform gelegt und lagegesichert wird, und daß die Leiterbahn (9, 9a) wenigstens teilweise mit Kunststoff umspritzt wird.

19. Verfahren nach Anspruch 18,
**dadurch gekennzeichnet, daß** die Leiterbahn (9, 9a) zwischen wenigstens zwei Haltestempeln (12, 13) der Spritzgußform eingespannt wird.

20. Verfahren nach Anspruch 19,
**dadurch gekennzeichnet, daß** wenigstens ein Haltestempel (12, 13) einen vorteilhaft unter Vakuum gesetzten Hohlraum (16, 16a, 17) aufweist, in dem das elektronische und/oder elektrische Bauteil (4, 4a) während des Spritzgußvorganges abgedichtet liegt.

21. Verfahren nach Anspruch 20,
**dadurch gekennzeichnet, daß** die Haltestempel (12, 13) die Leiterbahn (9, 9a) im Bereich des elektronischen und/oder elektrischen Bauteiles (4, 4a) einspannen.
